(19) Europäisches Patentamt
European Patent Office
Office européen des brevets

(11) **EP 3 424 114 B1**

(12) **FASCICULE DE BREVET EUROPEEN**

(45) Date de publication et mention de la délivrance du brevet:
**06.04.2022 Bulletin 2022/14**

(21) Numéro de dépôt: **17711578.9**

(22) Date de dépôt: **02.03.2017**

(51) Classification Internationale des Brevets (IPC):
**H01S 5/20** *(2006.01)*    **H01S 5/34** *(2006.01)*

(52) Classification Coopérative des Brevets (CPC):
**H01S 5/3402; H01S 5/2004;** H01S 5/3401

(86) Numéro de dépôt international:
**PCT/EP2017/054857**

(87) Numéro de publication internationale:
**WO 2017/149057 (08.09.2017 Gazette 2017/36)**

(54) **LASER À CASCADE QUANTIQUE**

QUANTENKASKADENLASER

QUANTUM CASCADE LASER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.03.2016 FR 1651796**

(43) Date de publication de la demande:
**09.01.2019 Bulletin 2019/02**

(73) Titulaires:
• **Centre National de la Recherche Scientifique 75016 Paris (FR)**
• **Université de Montpellier 34090 Montpellier (FR)**

(72) Inventeurs:
• **TEISSIER, Roland 34170 Castelnau-Le-Lez (FR)**
• **BARANOV, Alexei 34090 Montpellier (FR)**

(74) Mandataire: **IPAZ 10 boulevard Victor Hugo 34000 Montpellier (FR)**

(56) Documents cités:
**US-A1- 2013 121 361**

• **SPENCER P S ET AL: "QUANTUM WELL STRUCTURES FOR INTERSUBBAND SEMICONDUCTOR LASERS", INTERNATIONAL JOURNAL OF OPTOELECTRONICS (INCL.OPTICAL COMPUTING& PROCESSING), TAYLOR & FRANCIS, LONDON, GB, vol. 10, no. 5, 28 février 1996 (1996-02-28), pages 393-400, XP000618806, ISSN: 0952-5432**
• **MIRIAM SERENA VITIELLO ET AL: "Electronic and Thermal Properties of Sb-based QCLs operating in the first atmospheric window", SPIE, PO BOX 10 BELLINGHAM WA 98227-0010 USA, vol. 6485, 8 février 2007 (2007-02-08), - 8 février 2007 (2007-02-08), pages 1-11, XP040236050,**

## Description

La présente invention concerne un laser à cascade quantique.

Le domaine de l'invention est le domaine des lasers à semiconducteurs, et plus particulièrement le domaine des lasers à cascade quantique.

### Etat de la technique

Les lasers à cascade quantique sont des lasers réalisés à partir d'une hétérostructure semiconductrice constituée d'une région de gain formée par une structure à multi-puits quantique insérée entre deux couches de confinement, également appelées « cladding » en anglais, formant un guide d'onde optique. Une couche passive avec une absorption optique faible, appelée « spacer » en anglais, peut être disposée entre la région de gain et la couche de confinement.

La région de gain est généralement composée d'un empilement d'un ensemble de paires de couches comprenant une couche puits et une couche barrière.

Cette structure est pompée par un courant électrique circulant perpendiculairement aux couches qui la composent. Le champ électrique dans la région de gain peut atteindre une valeur très grande, de l'ordre de 10 kV/cm à plus de 100 kV/cm.

Cependant, les lasers à cascade quantique souffrent d'un courant parasite, également appelé « courant de trous », qui dégrade les performances du laser, en particulier à température ambiante. Ce courant est formé par des trous, générés dans la zone de sortie des électrons de la région de gain, et qui se propagent dans la région de gain. De plus, le courant de trous est activé thermiquement et peut être renforcé par un mécanisme d'ionisation par impact de trous.

La valeur du courant parasite augmente avec la diminution de l'énergie de bande interdite du matériau utilisé.

Un but de la présente invention est de remédier à ces inconvénients.

Un autre but de l'invention est de proposer un laser à cascade quantique présentant un courant de trous plus faible, voire nul.

Il est aussi un but de l'invention de proposer un laser à cascade quantique présentant de meilleures performances, en particulier à température ambiante.

Encore un autre but de l'invention est de proposer un laser à cascade quantique dont les performances sont moins dégradées même lorsque l'énergie de bande interdite du matériau utilisé est faible.

P. S. Spencer et K. A. Shore : "Quantum well structures for intersubband semiconductor lasers", (Incl. Optical Computing & Processing), Taylor & Francis, London GB, vol. 10, no. 5, 28 février 1996, p. 393-400 (XP000618806) divulgue un laser à cascade quantique avec une région de gain présentant une entrée et une sortie d'électrons et comportant en outre une région de blocage de porteurs de charge.

### Exposé de l'invention

L'invention permet d'atteindre au moins l'un de ces buts par un laser à cascade comme celui qui est défini dans les revendications indépendantes 1 et 14.

Ainsi, l'invention permet d'obtenir un laser à cascade quantique de meilleures performances, en particulier à température ambiante. De plus, les performances d'un tel laser à cascade quantique sont moins dégradées même lorsque l'énergie de bande interdite du matériau utilisé pour réaliser le laser selon l'invention est faible.

Plus particulièrement, la zone de blocage de trous peut être agencée au niveau de la jonction de la région de gain avec une couche de confinement, ou avec une couche passive de type spacer.

La zone de blocage de trous présente un profil d'énergie de bande de valence, qui diminue pour atteindre un minimum local puis qui augmente, dans le sens allant de l'entrée d'électrons dans la région de gain vers la sortie d'électrons de la région de gain.

Un tel profil d'énergie constitue une barrière efficace contre la propagation des trous dans la région de gain.

Dans le cas d'une zone constituée d'un empilement de couches puits et de couches barrière, par « profil d'énergie de bande de valence » on entend le profil obtenu par la position de la bande de valence dans les matériaux/couches puits, en excluant les discontinuités d'énergie dues aux matériaux/couches barrières.

Dans un mode de réalisation non limitatif, en aval du minimum local, dans le sens allant de l'entrée d'électrons vers la sortie d'électrons, l'énergie de bande de valence dans la zone de blocage peut augmenter d'une valeur prédéterminée supérieure ou égale à l'énergie thermique à température ambiante, en particulier supérieure ou égale à 25 meV, et préférentiellement supérieure ou égale à 50 meV.

Autrement dit, l'augmentation d'énergie de la bande de valence après le minimum local peut être d'une valeur prédéterminée supérieure ou égale à l'énergie thermique à la température maximale de fonctionnement visée

Suivant un exemple de réalisation préféré, mais nullement limitatif, la valeur prédéterminée est supérieure ou égale à 25meV.

Suivant un exemple de réalisation préféré, mais nullement limitatif, la valeur prédéterminée est supérieure ou égale à 50meV.

Les valeurs d'énergie données ci-dessus, sont particulièrement adaptées lorsque le matériau utilisé pour la couche puits est de l'InAs, sans être limitées à ce matériau.

Une telle augmentation d'énergie permet de créer une barrière énergétique efficace contre la propagation des trous dans la région de gain. Les trous sont ainsi cantonnés en aval du minimum local et ne peuvent pas passer en amont du minimum local.

Suivant une version préférée, la zone de blocage de trous peut présenter une énergie de bande interdite effective qui augmente, atteint une valeur maximale, puis diminue dans le sens allant de l'entrée d'électrons dans la région de gain vers la sortie d'électrons de la région de gain.

Dans la présente invention, l'« énergie de bande interdite effective » représente la somme de l'énergie de bande interdite entre la bande de valence et la bande de conduction du matériau puits, de l'énergie de confinement du premier niveau d'électrons et de l'énergie de confinement du premier niveau de trous.

Suivant un mode de réalisation, la région de gain et la zone de blocage peuvent, chacune, comprendre un empilement de couches puits et de couches barrière, et en particulier une répétition de paires de couches composées d'une couche puits et d'une couche barrière.

Dans une version avantageuse du laser selon l'invention, l'épaisseur d'au moins une couche puits de la zone de blocage peut être inférieure à l'épaisseur d'au moins une couche puits dans la région de gain.

Le fait que la zone de blocage comporte des couches puits de plus faible épaisseur par rapport à la région de gain permet de créer un minimum local dans le profil d'énergie de la bande de valence, respectivement un maximum local dans l'énergie de bande interdite effective.

Suivant un exemple de réalisation particulièrement avantageux, l'épaisseur des couches puits de la zone de blocage peut diminuer pour atteindre un minimum puis augmenter, dans le sens allant de l'entrée d'électrons dans la région de gain vers la sortie d'électrons de la région de gain.

En particulier, la diminution respectivement l'augmentation, de l'épaisseur des couches puits dans la zone de blocage peut être progressive ou discontinue.

Plus particulièrement, les couches puits de la zone de blocage peuvent avoir une épaisseur qui :

- diminue progressivement à partir d'une valeur, dite de départ, correspondant à l'épaisseur d'une couche puits, et en particulier de la dernière couche puits, dans la région de gain pour atteindre une valeur, dite minimale, correspondant à la moitié de ladite valeur de départ ;
- puis, augmente progressivement à partir de ladite valeur minimale pour atteindre une valeur, dite d'arrivée, supérieure ou égale à ladite valeur de départ.

En particulier, l'épaisseur d'au moins une couche puits de la zone de blocage peut être inférieure ou égale à 80%, et plus particulièrement inférieure ou égale à 50%, de l'épaisseur d'au moins une couche puits de région de gain.

Les inventeurs ont constaté qu'une épaisseur minimale de couche puits dans la zone de blocage égale à 50% de l'épaisseur maximale de couche puits dans la région de gain, permet d'obtenir une barrière efficace contre la propagation des trous dans la région de gain.

Alternativement ou en plus de ce qui vient d'être décrit pour les couches puits, l'épaisseur d'au moins une couche barrière de la zone de blocage peut avantageusement être supérieure à l'épaisseur d'au moins une couche barrière dans la région de gain.

Le fait que la zone de blocage comporte des couches barrière de plus grande épaisseur par rapport à la région de gain permet de créer un minimum local dans le profil d'énergie de la bande de valence, respectivement un maximum local dans l'énergie de bande interdite effective.

Suivant un exemple de réalisation particulièrement avantageux, l'épaisseur des couches barrière dans ladite zone de blocage peut augmenter pour atteindre un maximum puis diminuer, dans le sens allant de l'entrée d'électrons dans la région de gain vers la sortie d'électrons de la région de gain.

En particulier, l'augmentation, respectivement la diminution, de l'épaisseur des couches barrières dans la zone de blocage peut être progressive ou discontinue.

Plus particulièrement, les couches barrière de la zone de blocage peuvent avoir une épaisseur qui :

- augmente progressivement à partir d'une valeur, dite de départ, correspondant à l'épaisseur d'une couche barrière, et en particulier de la dernière couche barrière, dans la région de gain pour atteindre une valeur, dite maximale, correspondant au double de ladite valeur de départ ;
- puis, diminue progressivement à partir de ladite valeur maximale pour atteindre une valeur inférieure ou égale à ladite valeur de départ.

En particulier, l'épaisseur d'au moins une couche barrière de la zone de blocage peut être supérieure ou égale à 150%, et plus particulièrement supérieure ou égale à 200%, de l'épaisseur d'au moins une couche barrière dans la région de gain.

Les inventeurs ont constaté qu'une épaisseur maximale de couche barrière dans la zone de blocage égale à 200% de l'épaisseur minimale de couche barrière dans la région de gain, permet d'obtenir une barrière efficace contre la propagation des trous dans la région de gain.

Préférentiellement, dans la zone de blocage, au moins une, en particulier chaque, couche puits ou barrière peut être dopée de type N.

Le dopage de type N peut être plus important au centre la zone de blocage, par rapport au début et à la fin de ladite zone de blocage.

Tel que décrit plus haut, la région de gain, respectivement la zone de blocage, peut être formée par un empilement de plusieurs couches puits et de plusieurs couches barrière alternées.

Suivant un exemple de réalisation préféré, mais nullement limitatif, chaque couche puits de la région de gain, respectivement de la zone de blocage, peut être réalisée en Arséniure d'Indium (InAs).

Suivant un exemple de réalisation préféré, mais nullement limitatif, chaque couche barrière de la région de gain, respectivement de la zone de blocage, peut être réalisée en Antimoniure d'Aluminium (AlSb).

Suivant une première version du laser selon l'invention, lorsque la région de gain est réalisée par un empilement de couches puits et de couches barrière, et en particulier par un empilement de paires de couches composées d'une couche puits et d'une couche barrière superposées, alors la zone de blocage peut être formée par un sous ensemble dudit empilement de couches du côté de la sortie d'électrons, et en particulier au niveau de la jonction de ladite région de gain avec une couche de confinement, ou avec une couche passive de type spacer.

Suivant une deuxième version, la zone de blocage peut se présenter sous la forme d'un empilement de couches, indépendante(s) de la région de gain.

Une telle zone de blocage indépendante peut être disposée :

- au contact direct avec la région de gain, ou
- au contact indirect de la région de gain, par exemple par l'intermédiaire d'un injecteur.

La zone de blocage peut par exemple se trouver entre la région de gain et un spacer, du côté de la sortie des électrons de ladite région de gain.

Suivant un autre mode de réalisation, la zone de blocage peut ne pas être formée par un empilement de couches puits et barrière.

Dans ce mode de réalisation, la zone de blocage peut être formée par une unique couche, réalisée en un alliage dont la composition varie de manière continue, en vue de reproduire le profil d'énergie de bande de valence, et/ou le profil d'énergie de bande interdite effective, décrit(s) plus haut.

Un tel alliage peut être un alliage composé à partir d'un matériau de faible énergie de bande interdite, par exemple d'Arséniure d'Indium (InAs), et d'un matériau de grande énergie de bande interdite, par exemple Antimoniure d'Aluminium (AlSb).

Un tel alliage peut en particulier présenter un rapport R défini comme :

$$R = \text{(teneur en matériau de faible énergie de bande interdite)/(teneur en matériau de grande énergie de bande interdite)}$$

dont la valeur diminue progressivement, à partir d'une valeur de départ, pour atteindre une valeur minimale pour ensuite augmenter et atteindre une valeur, dite d'arrivée, en particulier supérieure ou égale à ladite valeur de départ.

Le laser à cascade quantique peut être utilisé pour générer une onde optique de longueur d'onde supérieure ou égale à $3\mu m$, en particulier supérieure ou égale à $12\mu m$, et encore plus particulièrement supérieure ou égale à $15\ \mu m$.

Le laser selon l'invention peut être utilisé pour la détection, la mesure et/ou le suivi de traces de gaz, tel que par exemple pour la surveillance de la pollution, pour des applications de contrôle, dans un but médical ou du respect des règles de droit, car un tel laser émet un rayonnement qui n'est pas absorbé par l'air propre, ou non pollué.

Le laser selon l'invention peut avantageusement être utilisé pour la spectroscopie moléculaire permettant notamment la détection, la mesure et/ou le suivi :

- de drogues telles que la cocaïne, l'héroïne, le cannabis ;
- d'hexafluorure de soufre (SF6) ou d'hexafluorure d'uranium ;
- de composés organiques volatiles, tels que le furane ou l'acide formique ;

- des composés utilisés pour la fabrication d'explosifs ; ou
- des oxydes d'azote.

## Description des figures et modes de réalisation

D'autres avantages et caractéristiques apparaîtront à l'examen de la description détaillée d'un mode de réalisation nullement limitatif, et des dessins annexés sur lesquels :

- la FIGURE 1 est une représentation schématique d'un exemple de réalisation d'un laser à cascade quantique de l'état de la technique ;
- la FIGURE 2 est une représentation schématique de la structure de bande du laser de la FIGURE 1 ;
- la FIGURE 3 est une représentation schématique d'un exemple de réalisation d'un laser à cascade quantique selon l'invention ; et
- la FIGURE 4 est une représentation schématique de la structure de bande du laser de la FIGURE 3.

Il est bien entendu que les modes de réalisation qui seront décrits dans la suite ne sont nullement limitatifs.

Sur les figures les éléments communs à plusieurs figures conservent la même référence.

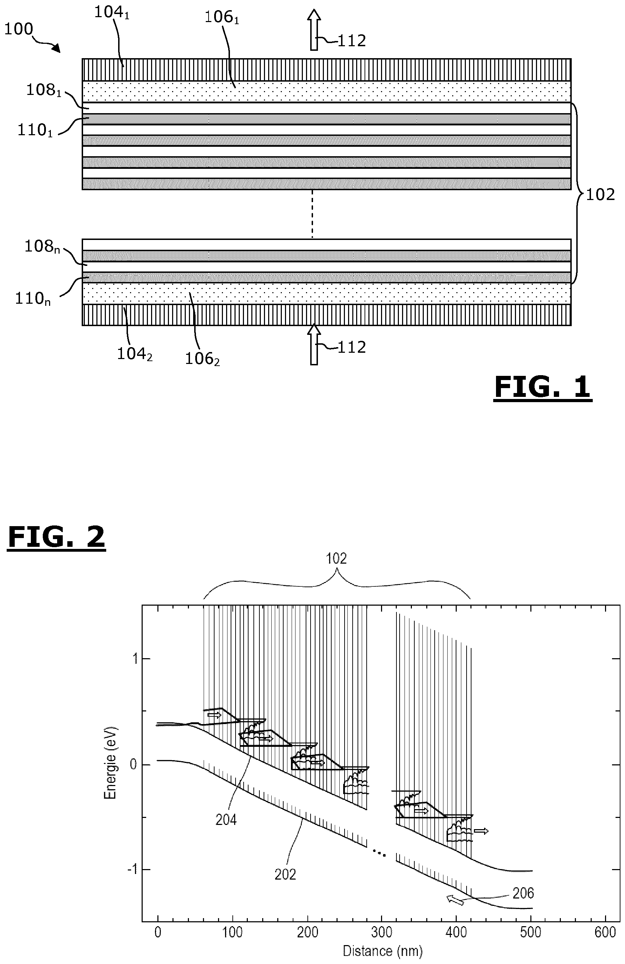

La FIGURE 1 est une représentation schématique d'un exemple de réalisation d'un laser à cascade quantique de l'état de la technique.

Le laser 100 représenté sur la FIGURE 1 comporte une région de gain 102 disposée entre deux couches de confinement, faites d'un matériau ayant un indice optique plus faible que celui de la région de gain, par exemple InAs dopé de type N, $104_1$ et $104_2$, également appelées « cladding », formant un guide d'onde optique.

La région de gain 102 et chaque couche de confinement $104_1$ et $104_2$ présente une épaisseur de l'ordre de quelques microns, typiquement 2 à 5.

Le laser 100 peut comporter en outre, entre la région de gain 102 et chaque couche de confinement, respectivement $104_1$ et $104_2$, une couche, respectivement $106_1$ et $106_2$, à très faible absorption optique, également appelée « spacer », réalisé par exemple avec de l'InAs faiblement dopé.

Chaque spacer $106_1$ et $106_2$ présente une épaisseur de l'ordre de quelques $\mu m$, typiquement 1 à 3.

La région de gain 102 est formée par des empilements de paires de couches comprenant une couche puits $108_i$ et une couche barrière $110_i$, avec $1<i<n$, avec n un nombre entier, par exemple égal à 400. Chaque couche puits 108 est réalisée en arséniure d'indium (InAs) et chaque couche barrière 110 est réalisée en AlSb.

Chaque couche puits 108 présente une épaisseur de l'ordre de 8 nm. Bien entendu, l'épaisseur des couches puits dans la région de gain 102 peuvent être variables.

De plus, chaque couche barrière 110 présente une épaisseur de l'ordre de 0.5 nm. Bien entendu, l'épaisseur des couches barrière dans la région de gain 102 peuvent être variables.

En fonctionnement, un courant électrique est pompé dans une direction perpendiculaire aux couches 104-110. Dans l'exemple représenté sur la FIGURE 1, le courant 112 entre dans le laser du côté des couches $104_2$ et $106_2$, et sort du laser 100 du côté des couches $104_1$ et $106_1$. Par conséquent, les porteurs de charge, c'est-à-dire les électrons, entrent dans la région de gain 102 du côté des couches $104_1$ et $106_1$ et sortent de la région de gain 102 du côté des couches $104_2$ et $106_2$.

La FIGURE 2 est une représentation schématique de la structure de bande d'énergies du laser de la FIGURE 1, en fonctionnement.

L'axe des ordonnées donne le niveau d'énergie par rapport à la distance, correspondant à l'épaisseur de la région de gain 102, le point 60nm correspondant à l'entrée des électrons dans la région de gain 102, c'est-à-dire à la première couche $108_1$ de la région de gain 102, et la distance 420 nm correspondant à la sortie des électrons dans la région de gain 102, c'est-à-dire à la dernière couche $110_n$ de la région de gain.

Ainsi, on constate que le profil d'énergie 202 de la bande de valence est un profil monotone et décroissant, si l'on exclut les discontinuités d'énergie de bande de valence dans les couches barrière $110_i$. Le même constat s'applique au profil d'énergie 204 de la bande de conduction.

Dans ces conditions, il apparait une population de trous dans la bande de valence, du côté de la sortie des électrons, c'est à dire du côté de la couche $110_n$, par génération thermique interbande ou ionisation par impact. Les trous générés traversent alors la bande de valence de la sortie d'électrons vers l'entrée des électrons, ce qui provoque l'apparition d'un courant de trous matérialisé par la flèche 206 sur la FIGURE 2.

Ce courant de trous 206 est un courant parasite et vient dégrader les performances du laser à cacade quantique 100.

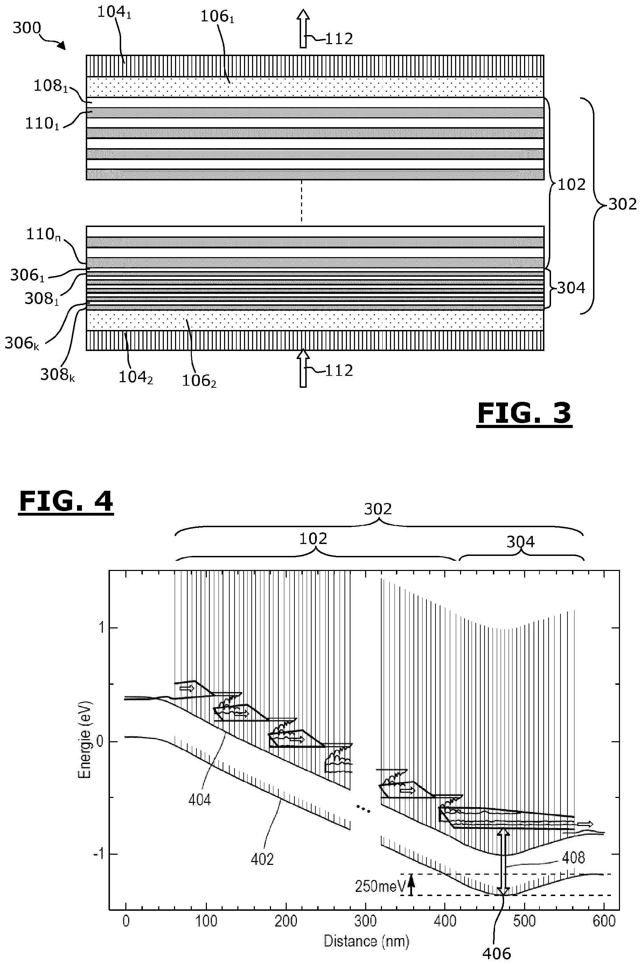

La FIGURE 3 est une représentation schématique d'un exemple de réalisation non limitatif d'un laser selon l'invention.

Le laser 300 selon l'invention comprend tous les éléments du laser 100 de la FIGURE 1.

En particulier, le laser 300 comprend la région de gain 102 du laser 100 de la FIGURE 1.

En plus, le laser comprend en plus de la région de gain 102, une zone de blocage 304, disposée entre la région de gain 102 et le spacer $106_2$ et formant une zone 302 se trouvant entre les spacers $106_1$ et $106_2$. Cette zone de blocage 304 a pour but de bloquer la propagation des trous dans la bande de valence depuis la sortie des électrons de la zone 302 jusqu'à l'entrée des électrons de la région de gain 102.

La zone de blocage 304 est formée par des empilements de paires de couches comprenant une couche puits $306_i$ et une couche barrière $308_i$, avec $1 < i < k$, avec $k$ un nombre entier, par exemple égal à 30. Chaque couche puits $306_i$ est réalisée en arséniure d'indium (InAs) et chaque couche barrière $308_i$ est réalisée en AlSb.

De plus, les couches puits $306_i$ de la zone de blocage 304 ont une épaisseur qui :

- diminue progressivement à partir d'une valeur, dite de départ, correspondant à l'épaisseur d'une couche puits $108_i$ dans la région de gain 102 pour atteindre une valeur, dite minimale, correspondant, par exemple, à la moitié de la valeur de départ ;
- puis, augmente progressivement à partir de ladite valeur minimale pour atteindre une valeur supérieure ou égale à ladite valeur de départ.

En particulier, la première couche puits $306_1$ de la zone de blocage 304 présente une épaisseur égale à la dernière couche puits $108_n$ de la région de gain 102, par exemple de l'ordre de 8nm. De plus, la dernière couche puits $306_k$ de la zone de blocage 304 présente une épaisseur supérieure ou égale à celle de la première couche puits $306_1$ de la zone de blocage 304. Entre la première couche puits $306_1$ et la dernière couche puits $306_k$ de la zone de blocage 304, l'épaisseur des couches puits $306_i$ diminue pour atteindre une valeur minimale, par exemple de 4nm, par exemple au niveau d'une couche puits se trouvant au centre de la zone de blocage 304, puis augmente pour atteindre une valeur supérieure ou égale à l'épaisseur de la première couche puits $306_1$ de la zone de blocage 304, par exemple une valeur de l'ordre de 8nm, au niveau de la dernière couche puits $306_k$ de la zone de blocage 304.

De plus, ou alternativement, les couches barrière $308_i$ de la zone de blocage 304 ont une épaisseur qui :

- augmente progressivement à partir d'une valeur, dite de départ, correspondant à l'épaisseur d'une couche barrière $110_i$ dans la région de gain 102 pour atteindre une valeur, dite maximale, correspondant, par exemple, au double de la valeur de départ ;
- puis, diminue progressivement à partir de ladite valeur maximale pour atteindre à nouveau une valeur au plus égale à la valeur de départ.

En particulier, la première couche barrière $308_1$ de la zone de blocage 304 présente une épaisseur égale à la dernière couche barrière $110_n$ de la région de gain 102, par exemple de l'ordre 0.5nm. De plus, la dernière couche barrière $308_k$ de la zone de blocage 304 présente une épaisseur inférieure ou égale à celle de la première couche barrière $308_1$ de la zone de blocage 304. Entre la première couche barrière $308_1$ et la dernière couche barrière $308_k$ de la zone de blocage 304, l'épaisseur des couches barrière $308_i$ augmente pour atteindre une valeur maximale, par exemple de 1 nm, par exemple au niveau de la couche barrière $308_i$ se trouvant au centre de la zone de blocage 304, puis diminue pour atteindre une valeur inférieure ou égale à l'épaisseur de la première couche barrière $308_1$ de la zone de blocage 304, par exemple une valeur de l'ordre de 0.5nm, au niveau de la dernière couche barrière $308_k$ de la zone de blocage 304.

De plus, chaque couche puits $306_i$ ou chaque couche barrière $308_i$ de la zone de blocage peut être dopée de type N. Le dopage est maximal dans la partie centrale de la zone de blocage 304.

Dans l'exemple qui vient d'être décrit, l'épaisseur des couches puits et des couches barrière de la zone de blocage varie. Bien entendu, l'invention n'est pas limitée à ce mode de réalisation. Par exemple, il est possible de concevoir un laser selon l'invention dans lequel seule l'épaisseur de couches puits, respectivement des couches barrière, de la zone de blocage présente la variation décrite ci-dessus.

En outre dans l'exemple qui vient d'être décrit, la zone de blocage est formée par un empilement de couches puits et barrières. Bien entendu, l'invention n'est pas limitée à ce mode de réalisation. Par exemple, il est possible de concevoir une zone de blocage se présentant sous la forme d'une unique couche, réalisée en un alliage dont la composition varie de manière continue. Une telle zone de blocage peut être réalisée par un alliage de matériau puits, par exemple d'Arséniure d'Indium (InAs), et de matériau barrière, par exemple Antimoniure d'Aluminium (AlSb), dont le rapport (teneur en matériau puits)/(teneur en matériau barrière) diminue progressivement, à partir d'une valeur de départ pour atteindre une valeur minimale, puis augmente pour atteindre une valeur d'arrivée, supérieure ou égale à ladite valeur de départ.

La FIGURE 4 est une représentation schématique de la structure de bandes d'énergies du laser de la FIGURE 3, en fonctionnement.

L'axe des ordonnées donne le niveau d'énergie par rapport à la distance, correspondant à l'épaisseur de la région de gain 102, le point 60nm correspondant à l'entrée des électrons dans la région de gain 102, c'est-à-dire à la première couche $108_1$ de la région de gain 102, et le point 420 nm correspondant à la couche barrière $110_n$ et à la couche puits $306_1$, c'est-à-dire au début de la zone de blocage 304. Le point 560nm correspond à la fin de la zone de blocage 304, et donc à la fin de la région de gain 102.

Ainsi, si l'on exclut les discontinuités d'énergie de bande dans les couches barrière $110_i$ et $308_i$, on constate que le profil d'énergie 402 de la bande de valence :

- décroit pour atteindre un minium local 406 au niveau d'une partie centrale de la zone de blocage 304, et en particulier au point 470nm ;
- puis croit pour atteindre le niveau d'énergie correspondant au début de la zone de blocage.

L'augmentation d'énergie après le minimum local 406 est de l'ordre de 250 meV dans l'exemple représenté sur la FIGURE 4.

Autrement dit, l'énergie de bande interdite effective est progressivement augmentée, en partant de l'énergie de bande interdite effective de la sortie de la région de gain 102, pour atteindre une valeur maximale 408, puis est progressivement réduite jusqu'à une valeur proche de la bande interdite de la région de spacer $106_2$ adjacente.

Ainsi, en fonctionnement, le minimum local 406 du profil d'énergie 402 de la bande de valence, respectivement le maximum local 408 de l'énergie de bande interdite effective, constitue une barrière de potentiel dans la bande de valence, qui s'oppose à la propagation des trous générés dans ladite bande de valence du côté de la sortie des électrons de la région 302, c'est-à-dire du côté de la couche $308_k$.

Les trous générés dans la bande de valence restent bloqués en aval dudit minimum local 406 du profil d'énergie 402 de la bande de valence, respectivement du maximum local 408 de l'énergie de bande interdite effective. Autrement dit, les trous générés dans la bande de valence restent bloqués entre ledit minimum, respectivement ledit maximum, et la sortie de des électrons de la région 302.

Bien entendu, l'invention n'est pas limitée aux exemples détaillés ci-dessus, étant donnée que l' invention est limitée par les revendications..

## Revendications

**1.** Laser (300) à cascade quantique comprenant une région de gain (102) insérée entre deux couches de confinement optique ($104_1$,$104_2$), ladite région de gain (102) présentant une entrée d'électrons dans la région de gain (102) et une sortie d'électrons de ladite région de gain (102), ledit laser comprenant une zone (304) de blocage de trous du côté de ladite sortie d'électrons, **caractérisé en ce que** ladite zone de blocage (304) de trous Présente un profil d'énergie de bande de valence (402) qui diminue pour atteindre un minimum local (406) puis augmente, dans le sens allant de l'entrée d'électrons dans la région de gain (102) vers la sortie d'électrons de la région de gain (102), ladite zone de blocage étant constituée d'un empilement de couches puits et de couches barrière, ledit profil d'énergie de bande de valence étant le profil obtenu par la position de la bande de valence dans les matériaux/couches puits, en excluant les discontinuités d'énergie dues aux matériaux/couches barrières.

**2.** Laser (300) selon la revendication 1, **caractérisé en ce que**, en aval du minimum local (406), dans le sens allant de l'entrée d'électrons vers la sortie d'électrons, l'énergie de bande de valence dans la zone de blocage (304) augmente d'une valeur supérieure ou égale à l'énergie thermique à température ambiante, en particulier supérieure ou égale à 25 meV, et préférentiellement supérieure ou égale à 50 meV.

**3.** Laser (300) selon l'une quelconque des revendications précédentes, **caractérisé en ce que** la zone de blocage (304) de trous présente une énergie de bande interdite effective (408) qui augmente, atteint une valeur maximale, puis diminue dans le sens allant de l'entrée d'électrons dans la région de gain (102) vers la sortie d'électrons de la région de gain (102).

**4.** Laser (300) selon l'une quelconque des revendications précédentes, **caractérisé en ce que** la région de gain (102) et la zone de blocage (304) comportent, chacune, un empilement de couches puits (108,306) et de couches barrière (110,308), l'épaisseur d'au moins une couche puits (306) de la zone de blocage (304) étant inférieure à l'épaisseur d'au moins une couche puits (108) dans la région de gain (102).

**5.** Laser (300) selon la revendication précédente, **caractérisé en ce que** l'épaisseur des couches puits (306) dans la zone de blocage (304) diminue pour atteindre un minimum puis augmente, dans le sens allant de l'entrée d'électrons dans la région de gain (102) vers la sortie d'électrons de la région de gain (102).

6. Laser (300) selon l'une quelconque des revendications 4 ou 5, **caractérisé en ce que**, l'épaisseur d'au moins une couche puits (306) de la zone de blocage (304) est inférieure ou égale à 80%, et plus particulièrement à 50%, de l'épaisseur d'au moins une couche puits (108) de la région de gain.

7. Laser (300) selon l'une quelconque des revendications précédentes, **caractérisé en ce que** la région de gain (102) et la zone de blocage (304) comportent, chacune, un empilement de couches puits (108,306) et de couches barrière (110,308), l'épaisseur d'au moins une couche barrière (308) de la zone de blocage (304) étant supérieure à l'épaisseur d'au moins une couche barrière (110) dans la région de gain (102).

8. Laser (300) selon la revendication précédente, **caractérisé en ce que** l'épaisseur des couches barrière (308) dans la zone de blocage (304) augmente pour atteindre un maximum puis diminue, dans le sens allant de l'entrée d'électrons dans la région de gain (102) vers la sortie d'électrons de la région de gain (102).

9. Laser (300) selon l'une quelconque des revendications 7 ou 8, **caractérisé en ce que** l'épaisseur d'au moins une couche barrière (308) de la zone de blocage (304) est supérieure ou égale à 150%, et plus particulièrement supérieure ou égale à 200%, de l'épaisseur d'au moins une couche barrière (110) dans la région de gain (102).

10. Laser (300) selon l'une quelconque des revendications précédentes, **caractérisée en ce que** la région de gain (102) comporte un empilement de couches puits (108,306) et de couches barrière (110,308), et **en ce que** dans la zone de blocage (304), au moins une, en particulier chaque, couche puits (306) ou barrière (308) est dopée de type N.

11. Laser (300) selon l'une quelconque des revendications précédentes, **caractérisée en ce que** la région de gain (102), respectivement la zone de blocage (304), est formée par un empilement de plusieurs couches puits (108,306) et de plusieurs couches barrière (110,308) alternées, et **en ce que** :

    - chaque couche puits (108, 306) est réalisée en Arséniure d'Indium (InAs) ; et/ou
    - chaque couche barrière (110,308) est réalisée en Antimoniure d'Aluminium (AlSb).

12. Laser (300) selon l'une quelconque des revendications précédentes, **caractérisée en ce que** la région de gain (102) comporte un empilement de couches puits (108,306) et de couches barrière (110,308), la zone de blocage (304) étant formée par un sous ensemble dudit empilement de couches du côté de la sortie d'électrons.

13. Laser selon l'une quelconque des revendications précédentes, **caractérisée en ce que** la zone de blocage se présente sous la forme d'un empilement de couches, indépendant de la région de gain.

14. Laser (300) à cascade quantique comprenant une région de gain (102) insérée entre deux couches de confinement optique ($104_1$,$104_2$), ladite région de gain (102) présentant une entrée d'électrons dans la région de gain (102) et une sortie d'électrons de ladite région de gain (102),

    ledit laser comprenant une zone (304) de blocage de trous du côté de ladite sortie d'électrons,
    **caractérisé en ce que** ladite zone de blocage (304) de trous présente un profil d'énergie de bande de valence (402) qui diminue pour atteindre un minimum local (406) puis augmente, dans le sens allant de l'entrée d'électrons dans la région de gain (102) vers la sortie d'électrons de la région de gain (102),
    la zone de blocage se présentant sous la forme d'une unique couche, réalisée en un alliage dont la composition varie de manière continue de façon à reproduire le profil d'énergie de bande de valence.

**Patentansprüche**

1. Quantenkaskadenlaser (300) mit einem zwischen zwei optischen Begrenzungsschichten ($104_1$, $104_2$) eingefügten Verstärkungsbereich (102), wobei der Verstärkungsbereich (102) einen Elektroneneinlass in den Verstärkungsbereich (102) und einen Elektronenauslass aus dem Verstärkungsbereich (102) aufweist, wobei der Laser eine Lochsperrzone (304) auf der Seite des Elektronenauslasses aufweist, **dadurch gekennzeichnet, dass** die Lochsperrzone (304) ein Valenzbandenergieprofil (402) aufweist, das in der Richtung vom Elektroneneinlass in den Verstärkungsbereich (102) zum Elektronenauslass aus dem Verstärkungsbereich (102) bis zu einem lokalen Minimum (406) absinkt und dann ansteigt, wobei die Sperrzone aus einem Stapel von Trogschichten und Barriereschichten besteht, wobei das Valenzbandenergieprofil das Profil ist, das durch die Position des Valenzbandes in den Trogmaterialien/-schichten erhalten wird, unter Ausschluss von Energiediskontinuitäten aufgrund der Barrierematerialien/-schichten.

**2.** Laser (300) nach Anspruch 1, **dadurch gekennzeichnet, dass** stromabwärts des lokalen Minimums (406) in der Richtung vom Elektroneneinlass zum Elektronenauslass die Valenzbandenergie in der Sperrzone (304) um einen Wert ansteigt, der größer oder gleich der thermischen Energie bei Raumtemperatur ist, insbesondere größer oder gleich 25 meV, und vorzugsweise größer oder gleich 50 meV.

**3.** Laser (300) nach einem der vorhergehenden Ansprüche, **dadurch gekennzeichnet, dass** die Lochsperrzone (304) eine effektive Bandlückenenergie (408) aufweist, die in der Richtung vom Elektroneneinlass in den Verstärkungsbereich (102) zum Elektronenauslass aus dem Verstärkungsbereich (102) ansteigt, einen Maximalwert erreicht und dann wieder absinkt.

**4.** Laser (300) nach einem der vorhergehenden Ansprüche, **dadurch gekennzeichnet, dass** der Verstärkungsbereich (102) und die Sperrzone (304) jeweils einen Stapel aus Trogschichten (108, 306) und Barriereschichten (110, 308) aufweisen, wobei die Dicke mindestens einer Trogschicht (306) in der Sperrzone (304) geringer ist als die Dicke mindestens einer Trogschicht (108) im Verstärkungsbereich (102).

**5.** Laser (300) nach dem vorhergehenden Anspruch, **dadurch gekennzeichnet, dass** die Dicke der Trogschichten (306) in der Sperrzone (304) in der Richtung vom Elektroneneinlass in den Verstärkungsbereich (102) zum Elektronenauslass aus dem Verstärkungsbereich (102) bis zu einem Minimum absinkt und dann ansteigt.

**6.** Laser (300) nach einem der Ansprüche 4 oder 5, **dadurch gekennzeichnet, dass** die Dicke mindestens einer Trogschicht (306) der Sperrzone (304) weniger als oder gleich 80%, insbesondere 50%, der Dicke mindestens einer Trogschicht (108) des Verstärkungsbereichs ist.

**7.** Laser (300) nach einem der vorhergehenden Ansprüche, **dadurch gekennzeichnet, dass** der Verstärkungsbereich (102) und die Sperrzone (304) jeweils einen Stapel aus Trogschichten (108, 306) und Barriereschichten (110, 308) aufweisen, wobei die Dicke mindestens einer Barriereschicht (308) in der Sperrzone (304) größer ist als die Dicke mindestens einer Barriereschicht (110) im Verstärkungsbereich (102).

**8.** Laser (300) nach dem vorhergehenden Anspruch, **dadurch gekennzeichnet, dass** die Dicke der Barriereschichten (308) in der Sperrzone (304) in der Richtung vom Elektroneneinlass in den Verstärkungsbereich (102) zum Elektronenauslass aus dem Verstärkungsbereich (102) bis zu einem Maximum ansteigt und dann absinkt.

**9.** Laser (300) nach einem der Ansprüche 7 oder 8, **dadurch gekennzeichnet, dass** die Dicke mindestens einer Barriereschicht (308) in der Sperrzone (304) größer oder gleich 150% und insbesondere größer oder gleich 200% der Dicke mindestens einer Barriereschicht (110) im Verstärkungsbereich (102) ist.

**10.** Laser (300) nach einem der vorhergehenden Ansprüche, **dadurch gekennzeichnet, dass** der Verstärkungsbereich (102) einen Stapel von Trogschichten (108, 306) und Barriereschichten (110, 308) aufweist, und dass in der Sperrzone (304) mindestens eine, insbesondere jede, Trogschicht (306) oder Barriereschicht (308) N-dotiert ist.

**11.** Laser (300) nach einem der vorhergehenden Ansprüche, **dadurch gekennzeichnet, dass** der Verstärkungsbereich (102) bzw. die Sperrzone (304) durch einen Stapel aus mehreren abwechselnden Trogschichten (108, 306) und mehreren Barriereschichten (110, 308) gebildet ist, und dass:

- jede Trogschicht (108, 306) aus Indiumarsenid (InAs) gebildet ist; und/oder
- jede Barriereschicht (110, 308) aus Aluminiumantimonid (AlSb) gebildet ist.

**12.** Laser (300) nach einem der vorhergehenden Ansprüche, **dadurch gekennzeichnet, dass** der Verstärkungsbereich (102) einen Stapel von Trogschichten (108, 306) und Barriereschichten (110, 308) aufweist, wobei die Sperrzone (304) durch eine Teilmenge des Schichtstapels auf der Elektronenauslassseite gebildet wird.

**13.** Laser nach einem der vorhergehenden Ansprüche, **dadurch gekennzeichnet, dass** die Sperrzone unabhängig vom Verstärkungsbereich in Form eines Schichtstapels vorliegt.

**14.** Quantenkaskadenlaser (300) mit einem zwischen zwei optischen Begrenzungsschichten ($104_1$, $104_2$) eingefügten Verstärkungsbereich (102), wobei der Verstärkungsbereich (102) einen Elektroneneinlass in den Verstärkungsbereich (102) und einen Elektronenauslass aus dem Verstärkungsbereich (102) aufweist, wobei der Laser eine Lochsperrzone (304) auf der Seite des Elektronenauslasses aufweist, **dadurch gekennzeichnet, dass** die Lochsperrzone (304) ein Valenzbandenergieprofil (402) aufweist, das in der Richtung vom Elektroneneinlass in den Verstärkungsbereich (102) zum Elektronenauslass aus dem Verstärkungsbereich (102) bis zu einem lokalen Minimum (406) absinkt und dann ansteigt,
wobei die Sperrzone in Form einer einzigen Schicht vorliegt, die aus einer Legierung gebildet ist, deren Zusammensetzung sich kontinuierlich ändert, um das ValenzbandEnergieprofil zu reproduzieren.

## Claims

1. A quantum cascade laser (300) comprising a gain region (102) inserted between two optical confinement layers ($104_1$,$104_2$), said gain region (102) having an electron input into the gain region (102) and an electron output from said gain region (102), said laser comprising a hole-blocking area (304) on the side of said electron output, **characterized in that** said hole-blocking area (304) having a valence-band energy profile (402), which decreases to reach a local minimum (406), then increases, in the direction going from the electron input into the gain region (102) to the electron output from the gain region (102),
said hole-blocking area being constituted by a stack of well layers and barrier layers, said valence-band energy profile being the profile obtained by the position of the valence band in the well layers/materials, excluding the energy discontinuities due to the barrier layers/materials.

2. The laser (300) according to claim 1, **characterized in that**, downstream of the local minimum (406), in the direction going from the electron input to the electron output, the valence-band energy in the hole-blocking area (304) increases by a value greater than or equal to the thermal energy at ambient temperature, in particular greater than or equal to 25 meV, and preferentially greater than or equal to 50 meV.

3. The laser (300) according to any one of the preceding claims, **characterized in that** the hole-blocking area (304) has an effective forbidden band energy (408) which increases, reaches a maximum value, then decreases in the direction going from the electron input into the gain region (102) to the electron output from the gain region (102).

4. The laser (300) according to any one of the preceding claims, **characterized in that** the gain region (102) and the hole-blocking area (304) each contain a stack of well layers (108,306) and barrier layers (110,308) the thickness of at least one well layer (306) of the hole-blocking area (304) being less than the thickness of at least one well layer (108) in the gain region (102).

5. The laser (300) according to the preceding claim, **characterized in that** the thickness of the well layers (306) in the hole-blocking area (304) decreases to reach a minimum then increases, in the direction going from the electron input into the gain region (102) to the electron output from the gain region (102).

6. The laser (300) according to either one of claims 4 or 5, **characterized in that** the thickness of at least one well layer (306) of the hole-blocking area (304) is less than or equal to 80%, and more particularly 50%, of the thickness of at least one well layer (108) of the gain region.

7. The laser (300) according to any one of the preceding claims, **characterized in that** the gain region (102) and the hole-blocking area (304) each contain a stack of well layers (108,306) and barrier layers (110,308), the thickness of at least one barrier layer (308) of the hole-blocking area (304) being greater than the thickness of at least one barrier layer (110) in the gain region (102).

8. The laser (300) according to the preceding claim, **characterized in that** the thickness of the barrier layers (308) in the hole-blocking area (304) increases to reach a maximum then decreases, in the direction going from the electron input into the gain region (102) to the electron output from the gain region (102).

9. The laser (300) according to either one of claims 7 or 8, **characterized in that** the thickness of at least one barrier layer (308) of the hole-blocking area (304) is greater than or equal to 150%, and more particularly greater than or equal to 200%, of the thickness of at least one barrier layer (110) in the gain region (102).

10. The laser (300) according to any one of the preceding claims, **characterized in that** the gain region (102) contains a stack of well layers (108,306) and barrier layers (110,308), and **in that** in the hole-blocking area (304) at least one, in particular each, well layer (306) or barrier layer (308) is of N-doped type.

11. The laser (300) according to any one of the preceding claims, **characterized in that** the gain region (102), respectively the hole-blocking area (304), is formed by a stack of several well layers (108,306) and several barrier layers (110,308) alternately, and **in that**:

  - each well layer (108,306) is produced from Indium Arsenide (InAs); and/or
  - each barrier layer (110,308) is produced from Aluminium Antimonide (AlSb).

12. The laser (300) according to any one of the preceding claims, **characterized in that** the gain region (102) comprises a stack of well layers (108,306) and barrier layers (110,308), the hole-blocking area (304) being formed by a sub-assembly of said stack of layers on the side of the electron output.

13. The laser according to any one of the preceding claims, **characterized in that** the hole-blocking area is formed in the form of a stack of layers, independent of the gain region.

14. A quantum cascade laser (300) comprising a gain region (102) inserted between two optical confinement layers $(104_1, 104_2)$, said gain region (102) having an electron input into the gain region (102) and an electron output from said gain region (102), said laser comprising a hole-blocking area (304) on the side of said electron output, **characterized in that** said hole-blocking area (304) having a valence-band energy profile (402), which decreases to reach a local minimum (406), then increases, in the direction going from the electron input into the gain region (102) to the electron output from the gain region (102), the hole-blocking area being constituted formed in the form of a single layer, produced from an alloy the composition of which varies continuously in order reproduce said valence-band energy profile.

**FIG. 1**

**FIG. 2**

**FIG. 3**

**FIG. 4**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- Quantum well structures for intersubband semiconductor lasers. **P. S. SPENCER ; K. A. SHORE.** Incl. Optical Computing & Processing. Taylor & Francis, 28 Février 1996, vol. 10, 393-400